# FASCICULE DE BREVET EUROPEEN

(11) **EP 4 018 549 B1**
(45) Date de publication et mention de la délivrance du brevet: **11.12.2024**
(21) Numéro de dépôt: 20757337.9
(22) Date de dépôt: 19.08.2020
(51) Int. Cl.: H03M 1/06, H03M 1/66

(54) **PROCEDE DE SYNCHRONISATION DE DONNEES ANALOGIQUES EN SORTIE D'UNE PLURALITE DE CONVERTISSEURS NUMERIQUE/ANALOGIQUE**
VERFAHREN ZUR SYNCHRONISIERUNG VON ANALOGDATEN AM AUSGANG EINER MEHRZAHL VON DIGITAL-/ANALOGWANDLERN
METHOD FOR SYNCHRONISING ANALOGUE DATA AT THE OUTPUT OF A PLURALITY OF DIGITAL/ANALOGUE CONVERTERS

(30) Priorité: 20.08.2019 FR 1909303
(43) Date de publication de la demande: 29.06.2022
(73) Titulaire: Teledyne E2V Semiconductors SAS, 38120 Saint-Egrève (FR)
(72) Inventeur: BUREAU-SUDREAU, Quentin, 38140 Rives (FR); LIGOZAT, Jérôme, 38000 Grenoble (FR); LAUBE, Rémi, 38113 Veurey-Voroize (FR); STACKLER, Marc, Jordan Hong Kon (HK)
(74) Mandataire: Murgitroyd & Company
(86) Numéro de dépôt international: PCT/EP2020/073161
(87) Numéro de publication internationale: WO 2021/032767

(56) Documents cités:
- EP-A1- 3 375 092
- EP-B1- 3 375 092
- WO-A2-2010/044838
- US-B1- 7 978 109

## Description

La présente invention concerne un procédé de synchronisation de données analogiques en sortie d'une pluralité de convertisseurs numérique/analogique sur un même front actif d'une horloge de référence commune. Elle concerne également un dispositif de synchronisation de données analogiques en sortie d'une pluralité de convertisseurs numérique/analogique sur un front actif d'une horloge de référence commune pour la mise en oeuvre du procédé de l'invention.

Pour certaines applications, comme les antennes matricielles ou les antennes MIMO (antennes à entrées et sorties multiples en français, ou « Multiple-Input, Multiple-Output » en anglais), utilisant plusieurs convertisseurs numérique/analogique et des données numériques entrantes en lien série, il est nécessaire de synchroniser les convertisseurs entre eux.

Pour cela, un signal de synchronisation fourni aux convertisseurs permet, dans un premier temps, de synchroniser les horloges internes des convertisseurs entre elles. Etant donnée la fréquence d'échantillonnage élevée des convertisseurs (de 1 à plusieurs Gigahertz), il est nécessaire que le signal de synchronisation soit très rapide, c'est-à-dire de quelques picosecondes, et qu'il intervienne dans une fenêtre temporelle très inférieure à une période d'horloge des horloges des convertisseurs.

Puis, dans un second temps, il faut aligner les données arrivant en entrée des convertisseurs entre elles. Or les temps de propagation des signaux sur les pistes d'une carte électronique sont de l'ordre de 6 ps/mm. Afin que toutes les données numériques, fournies en entrée des convertisseurs, arrivent en même temps sur tous les convertisseurs, il faut donc ajuster la longueur de piste transportant ces données. Pour certaines applications, la distance physique entre les composants rend cet alignement de longueur de piste délicat, voire impossible.

Pour pallier ce problème, différentes solutions existent pour synchroniser les convertisseurs quelles que soient les longueurs de piste jusqu'aux différents convertisseurs.

Une première solution consiste à envoyer une impulsion de synchronisation en phase à tous les convertisseurs, sa distribution étant conçue pour obtenir le temps de propagation adapté pour chaque convertisseur, pour que les fronts actifs d'horloge, sur lesquels les diviseurs de fréquence des convertisseurs seront initialisés, se correspondent. C'est-à-dire que deux à deux, les fronts actifs seront tous distants d'un nombre de période de l'horloge de référence qui est un multiple de N : 0, N, 2N, ... Tout est déterminé par la conception des chemins de distribution de l'horloge de référence et du signal de synchronisation sur chacun des convertisseurs. Cela nécessite une évaluation précise des délais de propagation sur chacun des convertisseurs. Cette première solution est assez simple à mettre en oeuvre lorsque les fréquences de travail sont faibles, mais quand elles sont supérieures à 100 MHz, il devient de plus en plus difficile d'évaluer les délais de propagation et de respecter les contraintes temporelles.

D'autres solutions modifient l'horloge d'échantillonnage, ce qui a pour effet de dégrader le signal de cette horloge par des problèmes de gigue et donc de dégrader les performances des convertisseurs.

Certaines solutions utilisent des sous-divisions de la fréquence d'échantillonnage et un système de maître/esclave entre les convertisseurs et le circuit électronique contrôlant le signal de synchronisation pour réaliser la synchronisation des convertisseurs entre eux. Néanmoins, elles limitent la tolérance en température du système et compliquent la gestion des horloges dans le système.

EP3375092A1 divulgue un dispositif de synchronisation de données analogiques en sortie d'une de la pluralité de convertisseurs numérique/analogique sur un front actif d'une de l'horloge de référence commune.

L'invention vise à remédier aux inconvénients précités de l'art antérieur, plus particulièrement elle vise à proposer une solution permettant de synchroniser les données analogiques en sortie des convertisseurs numérique/analogique sur un même front actif de l'horloge commune à tous les convertisseurs, la synchronisation étant réalisée en interne des convertisseurs.

Un objet de l'invention est donc un procédé de synchronisation de données analogiques en sortie d'une pluralité de convertisseurs numérique/analogique, comprenant au moins un coeur de conversion, sur un front actif d'une horloge de référence commune caractérisé en ce que le procédé comprend les étapes suivantes :
a) Fournir un signal de synchronisation externe, émis par une unité de commande, à au moins un convertisseur de la pluralité de convertisseurs, et fournir un signal d'horloge de l'horloge de référence commune à la pluralité de convertisseurs ;
b) Générer au sein de chaque convertisseur de la pluralité de convertisseurs un signal de synchronisation interne à partir du signal de synchronisation externe, tel que tous les signaux de synchronisation interne sont alignés sur un front actif de l'horloge de référence commune ;
c) Générer, par au moins un circuit électronique interne à chaque convertisseur de la pluralité de convertisseurs, un signal de démarrage représentatif du début de l'envoi de données numériques par l'unité de commande, sur chaque coeur de la pluralité des convertisseurs et compter un nombre de coups d'horloge entre la génération du signal de démarrage et la génération du signal de synchronisation interne pour chacun des coeurs de la pluralité de convertisseurs ;
d) Appliquer un retard Ri, à chaque coeur i de la pluralité de convertisseurs, égal à la différence entre le nombre compté le plus élevé dans l'étape c) et le nombre compté à l'étape c) pour le coeur i, i étant un entier compris entre 1 et le nombre de coeurs de la pluralité de convertisseurs.

Selon des modes de réalisation particuliers d'un tel procédé :
- Les signaux de synchronisation interne peuvent être générés à l'étape b) par un rééchantillonnage du signal de synchronisation externe.
- Les convertisseurs de la pluralité de convertisseurs peuvent formenr une chaîne de transmission série du signal de synchronisation externe, l'étape a) comprenant également :
   - l'initialisation dans chaque convertisseur de la pluralité de convertisseurs d'un circuit de synchronisation comportant au moins un paramètre de polarité définissant comme polarité d'un front d'horloge de référence, pour la détection de signal en entrée du circuit de synchronisation des convertisseurs, la polarité du front actif d'horloge de référence ou la polarité inverse ; et
l'étape b) comprenant également :
- la détection d'un signal de synchronisation en entrée des circuits de synchronisation de chaque convertisseur, sur un front d'horloge de référence, qui a la polarité définie par la valeur du paramètre de polarité du circuit de synchronisation ; et
- l'alignement sur le front actif suivant du signal détecté pour fournir un signal de synchronisation interne aligné sur un front actif d'horloge de référence en sortie du circuit de synchronisation du convertisseur.

Un autre objet de l'invention est un dispositif de synchronisation de données analogiques en sortie d'une pluralité de convertisseurs numérique/analogique sur un front actif d'une horloge de référence commune pour la mise en oeuvre d'un tel procédé, comprenant :
- une pluralité de convertisseurs numérique/analogique comprenant :
   - N coeurs de conversion et
   - N mémoires,

chaque convertisseur comprenant au moins une entrée numérique, au moins une sortie analogique, au moins une des N mémoires, au moins un des N coeurs de conversion et un circuit de synchronisation relié à l'entrée numérique, les circuits de synchronisation des convertisseurs étant connectés entre eux en cascade, les mémoires des convertisseurs étant chacune reliée à un coeur de conversion du convertisseur et le circuit de synchronisation des convertisseurs étant configuré de manière à générer un signal de synchronisation interne et à ce que les signaux de synchronisation interne générés soient alignés sur un front actif d'une horloge commune, et N étant un entier supérieur ou égal à 1 ; et
   - une unité de commande configurée de manière à envoyer un signal de l'horloge de référence commune, le signal de synchronisation externe et des données numériques à chaque convertisseur ;
caractérisé en ce que chaque convertisseur comprend également un circuit de décodage de données, comprenant un compteur, pour chaque coeur de conversion compris dans le convertisseur, les circuits de décodage de données étant placés en sortie du circuit de synchronisation et en entrée des mémoires et configurés de manière à générer les signaux de démarrage, représentatifs du début de l'envoi de données numériques sur un coeur de conversion et chaque compteur étant configuré de manière à compter le nombre de coups d'horloge entre la génération du signal de démarrage et la génération du signal de synchronisation interne du coeur de conversion, et en ce que la i-ème mémoire est configurée de manière à appliquer le retard Ri au i-ème coeur de conversion, i étant un entier compris entre 1 et N.

Selon des modes de réalisation particuliers d'un tel dispositif :
L'unité de commande peut comprendre au moins un circuit logique programmable configuré pour envoyer le signal de synchronisation externe.

L'unité de commande peut comprendre au moins un circuit logique programmable configuré pour envoyer les données numériques.

L'unité de commande peut également être configurée pour recevoir le nombre de coups d'horloge compté par les N compteurs, à déterminer les retards Ri et à fournir aux N mémoires une valeur du retard Ri à appliquer au i-ème coeur de conversion.

Les N mémoires peuvent être des registres à décalage.

La pluralité de convertisseurs peut comprendre N convertisseurs, chaque convertisseur comprenant un seul coeur de conversion parmi les N coeurs de conversion.

D'autres caractéristiques, détails et avantages de l'invention ressortiront à la lecture de la description faite en référence aux figures annexées données à titre d'exemple et qui représentent, respectivement :
[Fig.1], un schéma des étapes du procédé selon l'invention ;
[Fig.2], un dispositif permettant de mettre en oeuvre le procédé selon l'invention ; et
[Fig. 3], un exemple de convertisseur numérique/analogique à plusieurs coeurs de conversion permettant de mettre en oeuvre le procédé selon l'invention.

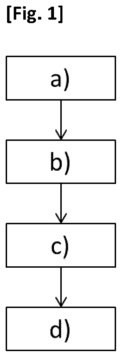

[Fig. 1] représente un schéma des étapes du procédé selon l'invention. La première étape, étape a), consiste à fournir à au moins un convertisseur d'une pluralité de convertisseurs numérique/analogique un signal de synchronisation externe SYNC_ext. Le signal de synchronisation externe SYNC_ext est émis par une unité de commande UC contrôlant la pluralité des convertisseurs.

La seconde étape, étape b), consiste à générer au sein de chaque convertisseur un signal de synchronisation interne SYNC_int. Ces signaux de synchronisation internes SYNC_int sont synchronisés entre eux sur un front actif d'une horloge commune de référence Clk.

L'alignement des signaux de synchronisation interne SYNC_int peut être fait à l'extérieur des convertisseurs en utilisant des lignes à retard, dédiées au signal de synchronisation externe SYNC_ext, entre l'unité de commande UC et les convertisseurs. Dans ce cas, tous les convertisseurs reçoivent directement et en même temps le signal de synchronisation externe SYNC_ext grâce aux lignes à retard et donc les signaux internes de synchronisation SYNC_int générés par les convertisseurs sont synchronisés sur le même front d'horloge. Le signal de synchronisation interne SYNC_int est dans ce cas généré directement, au sein de chaque convertisseur, à partir du signal de synchronisation externe SYNC_ext.

Cet alignement peut également se faire, de manière préférentielle, à l'intérieur des convertisseurs en utilisant la méthode décrite dans le brevet français n° 1560739. Cette méthode consiste à configurer la pluralité des convertisseurs en une chaîne série, et à remplacer la distribution en phase du signal de synchronisation SYNC_ext sur tous les convertisseurs, par une transmission de ce signal de synchronisation externe SYNC_ext d'un convertisseur à un autre pour atteindre de proche en proche tous les convertisseurs d'une chaîne. Autrement dit, seul le premier convertisseur reçoit directement le signal de synchronisation externe SYNC_ext, puis il génère un signal de synchronisation interne SYNC_int qu'il transmet au convertisseur suivant, qui lui-même génère un signal de synchronisation interne qu'il transmet à son tour au prochain convertisseur, jusqu'à atteindre le dernier convertisseur de la chaîne. Le signal de synchronisation interne SYNC_int est dans ce cas généré indirectement, au sein de chaque convertisseur, à partir du signal de synchronisation externe SYNC_ext, par transmission de proche en proche.

Cela est réalisé en combinaison avec un paramétrage de chaque convertisseur de la chaîne qui reflète les délais de propagation du signal de synchronisation SYNC_ext dans cette chaîne de convertisseurs et par lequel on transmet en sortie de chaque convertisseur, un signal de synchronisation interne SYNC_int qui est resynchronisé pour le convertisseur suivant.

Dans le cas de cette méthode, les convertisseurs forment une chaîne de transmission série d'un signal de synchronisation, c'est-à-dire que les convertisseurs comprennent chacun un circuit de synchronisation relié en série aux autres circuits de synchroisation des convertisseurs de la pluralité de convertisseur. De plus, l'étape a) du procédé comprend également l'initialisation dans chaque convertisseur de la pluralité de convertisseurs du circuit de synchronisation (CS, CS1, CS2, CSI) comportant au moins un paramètre de polarité définissant comme polarité d'un front d'horloge de référence, pour la détection de signal en entrée du circuit de synchronisation des convertisseurs, la polarité du front actif d'horloge de référence ou la polarité inverse.

L'étape b) comprend également la détection d'un signal de synchronisation (SYNC_ext, SYNC_int1, SYNC_int2) arrivant en entrée des circuits de synchronisation de chaque convertisseur et venant du circuit de synchronisation du convertisseur précédant dans la chaîne de transmission (ou de l'unité de commande pour le premier convertisseur de la chaîne), sur un front d'horloge de référence, qui a la polarité définie par la valeur du paramètre de polarité du circuit de synchronisation.

Puis, l'étape b) comprend l'alignement sur le front actif suivant du signal détecté pour fournir un signal de synchronisation interne (SYNC_int1, SYNC_int2, SYNC_intl) aligné sur un front actif d'horloge de référence en sortie du circuit de synchronisation du convertisseur.

Dans chaque convertisseur, le paramétrage permet également de choisir le bon front d'horloge de référence qui récupère le signal réinitialisant le générateur d'horloge d'échantillonnage, permettant de synchroniser en phase les horloges d'échantillonnage de tous les convertisseurs.

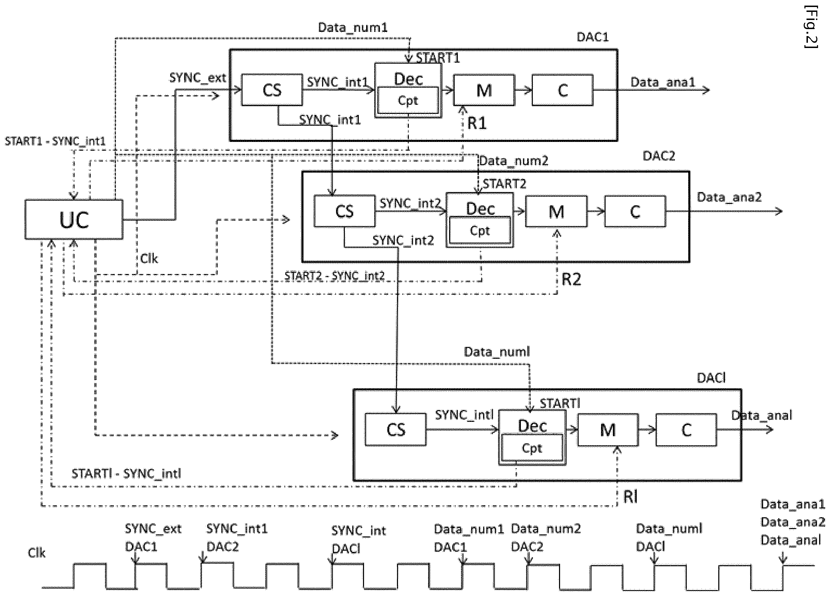

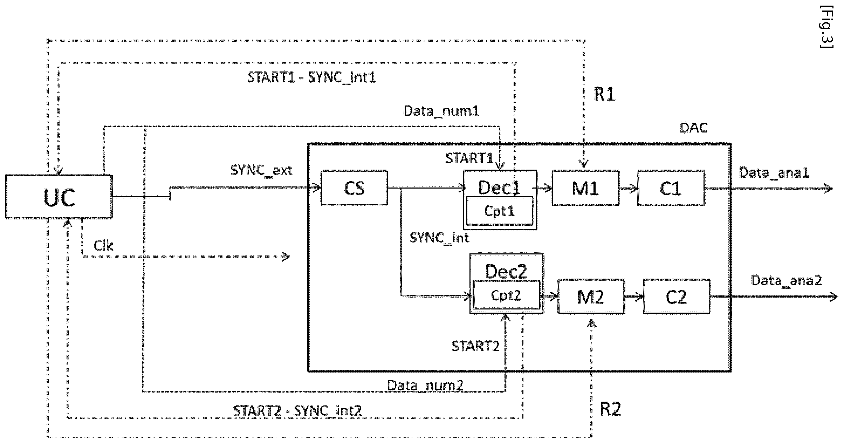

Puis la troisième étape du procédé selon l'invention, étape c), consiste à générer un signal de démarrage START représentatif du début de l'envoi de données numériques, par l'unité de commande, sur chaque coeur de la pluralité des convertisseurs. Ce signal de démarrage START est un signal interne à chaque convertisseur, émis pour chaque coeur de conversion, indiquant à tous les coeurs des convertisseurs que la prochaine donnée reçue par le coeur est la première donnée utile, donc la première donnée utile à convertir. Le ou les signaux de démarrage sont générés par le bloc de décodage du convertisseur comprenant un ou plusieurs circuits de décodage Dec selon le nombre de coeurs de conversion. Cela est décrit plus précisément en référence aux figures 2 et 3.

Ce signal START est généré suite à l'arrivée de la toute première donnée utile. Autrement dit, dès que le convertisseur reçoit la première donnée du lien série envoyé par l'unité de commande, il génère le signal START.

Puis, dans cette étape c), on compte le nombre de coups d'horloge entre la génération du signal de démarrage START et la génération du signal de synchronisation interne SYNC_int pour tous les coeurs de conversion. Cela peut être réalisé par un compteur Cpt présent dans chaque convertisseur et pour chaque coeur de conversion au sein des convertisseurs

Puis, dans la dernière étape, étape d), on applique un retard Ri, à chaque coeur i de la pluralité de convertisseurs, égal à la différence entre le nombre compté le plus élevé dans l'étape c) et le nombre compté à l'étape c) pour le coeur i, i étant un entier compris entre 1 et le nombre de coeurs de la pluralité de convertisseurs.

Par exemple, on considère trois convertisseurs ayant chacun un seul coeur de conversion. Le premier convertisseur compte 13 coups d'horloge entre la réception du signal START et de son signal de synchronisation interne SYNC_int, le second convertisseur compte 17 coups d'horloge et enfin le troisième convertisseur compte 14 coups d'horloge. Le nombre compté le plus élevé est 17, on appliquera donc un retard R1 au premier convertisseur égal à 17-13, soit un retard de 4 coups d'horloge. Pour le second convertisseur, son retard R2 sera égal à 0, car il constitue la référence et enfin pour le troisième convertisseur, on appliquera un retard R3 égale à 17-14 soit un retard de 3 coups d'horloge.

Si les convertisseurs comprennent plusieurs coeurs de conversion, on applique le même principe. On compte le nombre de coups d'horloge entre la réception du signal START et du signal de synchronisation interne SYNC_int pour chaque coeur de tous les convertisseurs, puis on applique à chaque coeur un retard égal à la différence entre le nombre compté le plus élevé pour tous les coeurs et tous les convertisseurs et le nombre compté pour le coeur considéré.

L'application d'un retard à chaque coeur permet ainsi de synchroniser tous les coeurs sur le coeur de conversion le plus lent et ainsi obtenir, en sortie des coeurs de conversion, des données converties et synchronisées sur le même front actif de l'horloge de référence commune.

[Fig. 2] présente un exemple d'un dispositif de synchronisation permettant de mettre en oeuvre le procédé selon l'invention, et d'appliquer la méthode du brevet français n° 1560739 pour l'étape b) du procédé.

Le dispositif comprend une unité de commande UC et une pluralité de convertisseurs numérique/analogique DAC1, DAC2, DACI. L'unité de commande UC fournit à au moins un convertisseur DAC1 de la pluralité des convertisseurs DAC1, DAC2, DACI un signal de synchronisation externe SYNC_ext. Elle fournit également un signal d'horloge de l'horloge commune de référence Clk et les données numériques Data_num1, Data_num2, Data_numl transmises en lien série à la pluralité des convertisseurs DAC1, DAC2, DACI.

Comme indiqué par la figure, la réception des signaux de synchronisation externe SYNC_ext par DAC1 et interne SYNC_int1 par DAC2 et SYNC_int2 par DACI, permettant de générer les signaux de synchronisation internes SYNC_int1, SYNC_int2 et SYNC_int1 selon la méthode du brevet français n° 1560739, ou des données numériques Data_num1, Data_num2, Data_numl sur les convertisseurs n'est pas synchronisée sur un même front actif de l'horloge Clk.

Chaque convertisseur DAC1, DAC2, DACI comprend, dans cet exemple, un circuit de synchronisation CS, un circuit de décodage de données Dec comprenant un compteur Cpt, une mémoire M et un coeur de conversion C.

Les circuits de synchronisation CS des convertisseurs DAC1, DAC2 et DACI forment une chaîne de transmission série. Ainsi, le circuit de synchronisation du premier convertisseur DAC1 est relié à l'unité de commande et sa sortie est reliée à l'entrée du circuit de synchronisation du second convertisseur DAC2. La sortie du circuit CS du second convertisseur DAC2 est reliée à l'entrée du circuit CS du troisième convertisseur DACI.

Le circuit de synchronisation CS va générer le signal de synchronisation interne SYNC_int1, SYNC_int2, SYNC_intl au sein de chaque convertisseur DAC1, DAC2, DACI de manière à ce que tous les signaux SYNC_int1, SYNC_int2, SYNC_intl des convertisseurs soient alignés sur un front actif de l'horloge commune Clk, ce qui correspond à l'exécution de l'étape b) du procédé selon l'invention.

Le circuit de décodage des données Dec reçoit le signal de synchronisation interne SYNC_int1 pour le convertisseur DAC1, SYNC_int2 pour le convertisseur DAC2 et SYNC_intl pour le convertisseur DACI de la part du circuit de synchronisation CS du convertisseur et les données numériques envoyées par l'unité de commande CS, Data_num1 sur le convertisseur DAC1, Data_num2 sur le convertisseur DAC2 et Data_numl sur le convertisseur DACI. Suite à la réception des données numériques, ce circuit de décodage des données Dec génère un signal START (START1 dans le convertisseur DAC1, START2 dans le convertisseur DAC2 et STARTI dans le convertisseur DACI) représentant la réception de la première donnée numérique par le convertisseur.

Le dispositif présenté sur cette figure permet d'appliquer la méthode du brevet français n° 1560739, donc seul le circuit de synchronisation CS du convertisseur DAC1 reçoit le signal de synchronisation externe SYNC_ext émis par l'unité de commande UC. Puis le circuit de synchronisation CS du DAC1 génère un signal de synchronisation interne SYNC_int1 qui est transmis au circuit de décodage Dec de DAC1 et au circuit de synchronisation CS du DAC2. Le circuit de synchronisation CS du DAC2 génère alors un signal de synchronisation interne SYNC_int2 qui est transmis au circuit de décodage Dec de DAC2 et au circuit de synchronisation CS du DACI. Le circuit de synchronisation CS du dernier convertisseur DACI génère un signal de synchronisation interne SYNC_intl qui est juste transmis au circuit de décodage Dec du dernier convertisseur DACI.

Le compteur Cpt présent dans les circuits de décodage Dec est configuré pour compter le nombre de coups d'horloge entre la génération du signal START et la génération du signal de synchronisation interne SYNC_int par le circuit de décodage Dec. Donc le compteur Cpt du convertisseur DAC1 compte le nombre de coups d'horloge entre le signal START1 et le signal de synchronisation SYNC_int1, le compteur Cpt du convertisseur DAC2 compte le nombre de coups d'horloge entre le signal START2 et le signal de synchronisation SYNC_int2 et le compte Cpt du convertisseur DACI compte le nombre de coups d'horloge entre le signal STARTI et le signal de synchronisation SYNC_intl.

La mémoire M est configurée pour appliquer un retard Ri à la transmission des données à convertir entre le circuit de décodage des données Dec et le coeur de conversion C. Ce retard Ri est celui décrit dans l'étape d) en référence à la figure 1. Il est donc égal à la différence entre le nombre de coups d'horloge compté par tous les compteurs le plus élevé et le nombre de coups d'horloge compté pour le convertisseur comprenant cette mémoire.

Pour calculer ce retard, le compteur Cpt peut envoyer le nombre de coups d'horloge comptés à l'unité de commande UC qui analyse tous les comptes reçus pour déterminer quel est le convertisseur (en particulier le coeur de conversion) le plus lent, c'est-à-dire le coeur de conversion fournissant les données analogiques en dernier parmi tous les coeurs de la pluralité de convertisseurs. Puis, l'unité de commande UC contrôle ensuite les retards Ri : R1, R2, RI appliqués par les différentes mémoires M.

Enfin, le coeur de conversion C est configuré pour réaliser la conversion des données numériques Data_num1, Data_num2, Data_numl en données analogiques Data_ana1, Data_ana2, Data_anal récupérées en sortie du convertisseur DAC1, DAC2, DACI. Toutes les données analogiques Data_ana1, Data_ana2, Data_anal en sortie des coeurs de conversion C sont alors alignées sur un même front actif de l'horloge Clk.

[Fig.3] présente un autre exemple de dispositif permettant de mettre en oeuvre le procédé selon l'invention, et plus particulièrement un exemple de convertisseur DAC ayant plusieurs coeurs de conversion C1 et C2.

Dans le cas d'un convertisseur ayant deux coeurs de conversion C1 et C2, le convertisseur DAC comprend un circuit de synchronisation CS, deux circuits de décodage des données Dec1 et Dec2, donc deux compteurs Cpt1 et Cpt2 et deux mémoires M1 et M2. Le circuit de synchronisation CS reçoit un signal de synchronisation externe SYNC_ext venant de l'unité de commande UC, puis génère un signal de synchronisation interne SYNC_int qui est transmis aux deux circuits de décodage des données Dec1 et Dec2.

Les circuits de décodage Dec1 et Dec2 sont chacun reliés au même circuit de synchronisation CS, mais sont chacun reliés à une mémoire et un coeur (M1 et C1 pour le circuit Cpt1 et M2 et C2 pour le circuit Cpt2).

Le circuit de synchronisation CS peut également recevoir un signal de synchronisation venant d'un autre convertisseur, si le convertisseur DAC appartient à une pluralité de convertisseurs, comme décrit dans la figure 2.

Puis chacun des circuits de décodage de données Dec1 et Dec2 reçoit des données numériques Data_num1 pour Dec1 et Data_num2 pour Dec2 de la part de l'unité de commande UC et génère donc chacun un signal START1 et START2 représentant l'arrivée de la première donnée à convertir sur le coeur de conversion C1 et C2.

Le compteur Cpt1 du circuit de décodage Dec1 compte alors le nombre de coups d'horloge entre la génération du signal START1 et celle du signal SYNC_int, tandis que le compteur Cpt2 du circuit de décodage Dec2 compte le nombre de coups d'horloge entre la génération du signal START2 et celle du signal SYNC_int.

L'unité de commande UC reçoit donc de la part des deux compteurs Cpt1, Cpt2 les nombres de coups d'horloge comptés et peut alors déterminer quel est le coeur de conversion le plus lent parmi les coeurs C1 et C2 du convertisseur, et plus généralement parmi tous les coeurs de conversion répartis dans les convertisseurs. Le coeur le plus lent sera alors la référence pour calculer le retard à appliquer aux autres coeurs de conversion.

Ensuite, les mémoires M1 et M2 sont configurées pour appliquer un retard R1 et R2 et ainsi synchroniser l'arrivée des données à convertir sur chaque coeur sur le coeur de plus lent.

L'unité de commande UC peut être réalisée par un circuit logique programmable de type FPGA. Elle est conçue pour contrôler tous les convertisseurs DAC1, DAC2, DACI et tous leurs coeurs de conversion C1, C2, suivant un schéma de communication maître/esclave, au moven d'un bus d'interface périphérique comme le bus SPI (Serial Peripherical Interface) qui est un bus de données série synchrone très utilisé. Le bus SPI permet l'échange de données entre l'unité de commande UC et les convertisseurs DAC1, DAC2, DACI et leurs coeurs C1, C2, en particulier des données qui sont les données à convertir.

L'unité de commande UC peut également comprendre un ou plusieurs circuits logiques programmables de type FPGA. Dans le cas de plusieurs circuits, un circuit FPGA peut être dédié à l'envoi des données numériques aux convertisseurs, tandis qu'un second circuit FPGA peut être dédié à l'envoi du signal de synchronisation externe SYNC_ext. Il est également possible d'avoir des circuits FPGA dédiés pour l'envoi des données numériques, un circuit étant dédié à un convertisseur.

Les mémoires M présentes dans les convertisseurs DAC, DAC1, DAC2, DACI peuvent être des registres à décalage dont la longueur du registre est égale à la différence entre le nombre de coups d'horloge compté le plus élevé parmi tous les coeurs des convertisseurs et le nombre compté pour le coeur relié à ce registre.

## Revendications

1. Procédé de synchronisation de données analogiques (Data_anal, Data_ana2, Data_anal) en sortie d'une pluralité de convertisseurs numérique/analogique (DAC, DAC1, DAC2, DACI), comprenant au moins un coeur de conversion (C, C1, C2), sur un front actif d'une horloge de référence commune (Clk), dans laquelle le procédé comprend les étapes suivantes :
a) Fournir un signal de synchronisation externe (SYNC_ext), émis par une unité de commande (UC), à au moins un convertisseur de la pluralité de convertisseurs, et fournir un signal d'horloge de l'horloge de référence commune à la pluralité de convertisseurs ;
b) Générer au sein de chaque convertisseur de la pluralité de convertisseurs un signal de synchronisation interne (SYNC_int, SYNC_int1, SYNC_int2, SYNC_intl) basé sur le signal de synchronisation externe, tel que tous les signaux de synchronisation interne sont alignés sur un front actif de l'horloge de référence commune ;
c) Générer, par au moins un circuit électronique interne à chaque convertisseur de la pluralité de convertisseurs, un signal de démarrage (START1, START2, STARTI) représentatif du début de l'envoi de données numériques (Data_numl, Data_num2, Data_numl) par l'unité de commande, sur chaque coeur de la pluralité des convertisseurs et compter un nombre de coups d'horloge entre la génération du signal de démarrage et la génération du signal de synchronisation interne pour chacun des coeurs de la pluralité de convertisseurs, et
d) Appliquer un retard Ri (RI, R2, RI), à chaque coeur i de la pluralité de convertisseurs, égal à la différence entre le nombre compté le plus élevé dans l'étape c) et le nombre compté à l'étape c) pour le coeur i, i étant un entier compris entre 1 et le nombre de coeurs de la pluralité de convertisseurs.

2. Procédé de synchronisation de données analogiques selon la revendication 1 dans lequel les signaux de synchronisation interne sont générés à l'étape b) par un rééchantillonnage du signal de synchronisation externe.

3. Procédé de synchronisation de données analogiques selon l'une des revendications précédentes dans lequel les convertisseurs de la pluralité de convertisseurs forment une chaîne de transmission série du signal de synchronisation externe et l'étape a) comprend également :
- l'initialisation dans chaque convertisseur de la pluralité de convertisseurs d'un circuit de synchronisation (CS, CS1, CS2, CSI) comportant au moins un paramètre de polarité définissant comme polarité d'un front d'horloge de référence, pour la détection de signal en entrée du circuit de synchronisation des convertisseurs, la polarité du front actif d'horloge de référence ou la polarité inverse ; et
l'étape b) comprend également :
- la détection d'un signal de synchronisation (SYNC_ext, SYNC_int1, SYNC_int2) en entrée des circuits de synchronisation de chaque convertisseur, sur un front d'horloge de référence, qui a la polarité définie par la valeur du paramètre de polarité du circuit de synchronisation ; et
- l'alignement sur le front actif suivant du signal détecté pour fournir un signal de synchronisation interne (SYNC_int1, SYNC_int2, SYNC_intl) aligné sur un front actif d'horloge de référence en sortie du circuit de synchronisation du convertisseur.

4. Dispositif de synchronisation de données analogiques en sortie de la pluralité de convertisseurs numérique/analogique sur un front actif de l'horloge de référence commune (Clk) pour la mise en oeuvre du procédé selon la revendication précédente, le dispositif comprenant :
- la pluralité de convertisseurs numérique/analogique (DAC, DAC1, DAC2, DACI) comprenant :
- N coeurs de conversion (C, C1, C2) et
- N mémoires (M, M1, M2), chaque convertisseur comprenant au moins une entrée numérique, au moins une sortie analogique, au moins une des N mémoires, au moins un des N coeurs de conversion et un circuit de synchronisation (CS, CS1, CS2, CSI) relié à l'entrée numérique, les circuits de synchronisation des convertisseurs étant connectés entre eux en cascade, les mémoires des convertisseurs étant chacune reliée à un coeur de conversion du convertisseur et le circuit de synchronisation des convertisseurs étant configuré de manière à générer le signal de synchronisation interne (SYNC_int, SYNC_int1, SYNC_int2, SYNC_intl) et à ce que les signaux de synchronisation interne
générés soient alignés sur un front actif d'une horloge commune, et N étant un entier supérieur ou égal à 1 ; et
- l'unité de commande (UC) configurée de manière à envoyer un signal de l'horloge de référence commune (Clk), le signal de synchronisation externe (SYNC_ext) et des données numériques (Data_num1, Data_num2, Data_numl) à chaque convertisseur ; **Caractérisé en ce que** chaque convertisseur comprend également un circuit de décodage de données (Dec1, Dec2, Dec), comprenant un compteur (Cpt, Cpt1, Cpt2), pour chaque coeur de conversion compris dans le convertisseur, les circuits de décodage de données étant placés en sortie du circuit de synchronisation et en entrée des mémoires et configurés de manière à générer les signaux de démarrage (START1, START2, STARTI), représentatifs du début de l'envoi de données numériques sur un coeur de conversion et chaque compteur étant configuré de manière à compter le nombre de coups d'horloge entre la génération du signal de démarrage et la génération du signal de synchronisation interne du coeur de conversion, et **en ce que** la i-ème mémoire est configurée de manière à appliquer le retard Ri (R1, R2, RI) au i-ème coeur de conversion, i étant un entier compris entre 1 et N.

5. Dispositif de synchronisation de données analogiques selon la revendication précédente dans lequel l'unité de commande comprend au moins un circuit logique programmable configuré pour envoyer le signal de synchronisation externe.

6. Dispositif de synchronisation de données analogiques selon l'une des revendications 4 ou 5 dans lequel l'unité de commande comprend au moins un circuit logique programmable configuré pour envoyer les données numériques.

7. Dispositif de synchronisation de données analogiques selon l'une des revendications 4 à 6 dans lequel l'unité de commande est également configurée pour recevoir le nombre de coups d'horloge compté par les N compteurs, à déterminer les retards Ri et à fournir aux N mémoires une valeur du retard Ri à appliquer au i-ème coeur de conversion.

8. Dispositif de synchronisation de données analogiques selon l'une des revendications 4 à 7 dans lequel les N mémoires sont des registres à décalage.

9. Dispositif de synchronisation de données analogiques selon l'une des revendications 4 à 8 dans lequel la pluralité de convertisseurs comprend N convertisseurs, chaque convertisseur comprenant un seul coeur de conversion parmi les N coeurs de conversion.

10. Procédé selon la revendication 1 dans lequel le signal de synchronisation externe (SYNC_ext) est fourni à chaque convertisseur de la pluralité de convertisseurs via une ligne à retard respective entre l'unité de commande (UC) et chaque convertisseur.

11. Procédé selon la revendication 1 dans lequel :
le signal de synchronisation externe (SYNC_ext) est fourni à un premier convertisseur de la pluralité de convertisseurs, dans lequel chaque convertisseur de la pluralité de convertisseurs comprend un circuit de synchronisation, et dans lequel les circuits de synchronisation de la pluralité de convertisseurs forment une chaîne de transmission en série pour le signal de synchronisation externe; et la génération du signal de synchronisation interne comprend :
la génération, dans le premier convertisseur, du signal de synchronisation interne (SYNC_int1) à partir du signal de synchronisation externe reçu à une entrée du circuit de synchronisation du premier convertisseur ; et
la génération, dans chaque convertisseur restant de la pluralité de convertisseurs, du signal de synchronisation interne (SYNC_int2, SYNC_intl) à partir du signal de synchronisation interne transmis par un convertisseur précédent dans la chaîne de transmission en série et arrivant à une entrée du circuit de synchronisation du convertisseur.

## Patentansprüche

1. Ein Verfahren zum Synchronisieren von analogen Daten (Data_anal, Data_ana2, Data_anal) an einem Ausgang einer Vielzahl von Digital-Analog-Wandlern (DAC, DAC1, DAC2, DACI), die mindestens einen Wandlungskern (C, C1, C2) beinhalten, auf eine aktive Flanke eines gemeinsamen Referenztakts (Clk), wobei das Verfahren die folgenden Schritte beinhaltet:
a) Bereitstellen eines externen Synchronisationssignals (SYNC_ext), das von einer Steuereinheit (UC) ausgegeben wird, für mindestens einen der Vielzahl von Wandlern und Bereitstellen eines Taktsignals des gemeinsamen Referenztakts für die Vielzahl von Wandlern;
b) Erzeugen, in jedem Wandler der Vielzahl von Wandlern, eines internen Synchronisationssignals (SYNC_int, SYNC_int1, SYNC_int2, SYNC_intl) basierend auf dem externen Synchronisationssignal, sodass alle internen Synchronisationssignale an einer aktiven Flanke des gemeinsamen Referenztakts ausgerichtet sind;
c) Erzeugen, durch mindestens eine elektronische Schaltung, die in jedem Wandler der Vielzahl von Wandlern intern ist, eines Startsignals (START1, START2, STARTI), das den Beginn des Sendens digitaler Daten (Data_numl, Data_num2, Data_numl) durch die Steuereinheit repräsentiert, an jedem Kern der Vielzahl von Wandlern, und Zählen einer Anzahl von Taktschlägen zwischen der Erzeugung des Startsignals und der Erzeugung des internen Synchronisationssignals für jeden der Kerne der Vielzahl von Wandlern; und
d) Anwenden einer Verzögerung Ri (RI, R2, RI) auf jeden Kern i der Vielzahl von Wandlern, die gleich der Differenz zwischen der höchsten in Schritt c) gezählten Zahl und der in Schritt c) für den Kern i gezählten Zahl ist, wobei i eine ganze Zahl zwischen 1 und der Anzahl der Kerne der Vielzahl von Wandlern ist.

2. Verfahren zum Synchronisieren von analogen Daten gemäß Anspruch 1, wobei die internen Synchronisationssignale in Schritt b) durch eine erneute Abtastung des externen Synchronisationssignals erzeugt werden.

3. Verfahren zum Synchronisieren von analogen Daten gemäß einem der vorhergehenden Ansprüche, wobei die Wandler der Vielzahl von Wandlern eine Kette zur seriellen Übertragung des externen Synchronisationssignals bilden und Schritt a) ferner Folgendes beinhaltet:
- Initialisieren, in jedem Wandler der Vielzahl von Wandlern, einer Synchronisationsschaltung (CS, CS1, CS2, CSI), umfassend mindestens einen Polaritätsparameter, der, als Polarität einer Referenztaktflanke, für die Detektion eines Signals an dem Eingang der Synchronisationsschaltung der Wandler, die Polarität der aktiven Referenztaktflanke oder die umgekehrte Polarität definiert; und
Schritt b) ferner Folgendes beinhaltet:
- Detektieren eines Synchronisationssignals (SYNC_ext, SYNC_int1, SYNC_int2) an dem Eingang der Synchronisationsschaltungen jedes Wandlers an einer Referenztaktflanke, das die Polarität aufweist, die durch den Wert des Polaritätsparameters der Synchronisationsschaltung definiert ist; und
- Ausrichten, auf die nächste aktive Flanke, des detektierten Signals, um ein internes Synchronisationssignal (SYNC_int1, SYNC_int2, SYNC_intl) bereitzustellen, das auf eine aktive Flanke des Referenztakts an dem Ausgang der Synchronisationsschaltung des Wandlers ausgerichtet ist.

4. Eine Vorrichtung zum Synchronisieren von analogen Daten an dem Ausgang der Vielzahl von Digital-Analog-Wandlern mit einer aktiven Flanke des gemeinsamen Referenztakts (Clk) zur Durchführung des Verfahrens gemäß dem vorhergehenden Anspruch, wobei die Vorrichtung Folgendes beinhaltet:
- die Vielzahl von Digital-Analog-Wandlern (DAC, DAC1, DAC2, DACI), die Folgendes beinhaltet:
- N Wandlungskerne (C, C1, C2) und
- N Speicher (M, M1, M2), wobei jeder Wandler mindestens einen digitalen Eingang, mindestens einen analogen Ausgang, mindestens einen der N Speicher, mindestens einen der N Wandlungskerne und eine Synchronisationsschaltung (CS, CS1, CS2, CSI), die mit dem digitalen Eingang verbunden ist, beinhaltet, wobei die Synchronisationsschaltungen der Wandler miteinander in Kaskade geschaltet sind, wobei die Speicher der Wandler jeweils mit einem Wandlungskern des Wandlers verbunden sind und die Synchronisationsschaltung der Wandler so konfiguriert ist, dass sie das interne Synchronisationssignal (SYNC_int, SYNC_int1, SYNC_int2, SYNC_intl) erzeugt und die erzeugten internen Synchronisationssignale auf eine aktive Flanke eines gemeinsamen Takts ausgerichtet sind, und wobei N eine ganze Zahl größer oder gleich 1 ist; und
- die Steuereinheit (UC), so konfiguriert, dass sie ein Signal des gemeinsamen Referenztakts (Clk), das externe Synchronisationssignal (SYNC_ext) und digitale Daten (Data_num1, Data_num2, Data_numl) an jeden Wandler sendet;
**dadurch gekennzeichnet, dass** jeder Wandler auch eine Datendekodierschaltung (Dec1, Dec2, Dec), die einen Zähler (Cpt, Cpt1, Cpt2) beinhaltet, für jeden in dem Wandler enthaltenen Wandlungskern beinhaltet, wobei die Datendekodierschaltungen an dem Ausgang der Synchronisationsschaltung und an dem Eingang der Speicher angeordnet sind und so konfiguriert sind, dass sie die Startsignale (START1, START2, STARTI) erzeugen, die den Beginn des Sendens von digitalen Daten an einen Wandlungskern darstellen, und jeder Zähler so konfiguriert ist, dass er die Anzahl der Taktschläge zwischen der Erzeugung des Startsignals und der Erzeugung des internen Synchronisationssignals des Wandlungskerns zählt, und dass der i-te Speicher so konfiguriert ist, dass er die Verzögerung Ri (R1, R2, RI) auf den i-ten Wandlungskern anwendet, wobei i eine ganze Zahl zwischen 1 und N ist.

5. Vorrichtung zum Synchronisieren von analogen Daten gemäß dem vorhergehenden Anspruch, wobei die Steuereinheit mindestens eine programmierbare Logikschaltung beinhaltet, die so konfiguriert ist, dass sie das externe Synchronisationssignal sendet.

6. Vorrichtung zum Synchronisieren von analogen Daten gemäß einem der Ansprüche 4 oder 5, wobei die Steuereinheit mindestens eine programmierbare Logikschaltung beinhaltet, die so konfiguriert ist, dass sie die digitalen Daten sendet.

7. Vorrichtung zum Synchronisieren von analogen Daten gemäß einem der Ansprüche 4 bis 6, wobei die Steuereinheit auch so konfiguriert ist, dass sie die von den N Zählern gezählte Anzahl von Taktschlägen empfängt, dass sie die Verzögerungen Ri bestimmt und dass sie den N Speichern einen Wert für die auf den i-ten Wandlungskern anzuwendende Verzögerung Ri liefert.

8. Vorrichtung zum Synchronisieren von analogen Daten gemäß einem der Ansprüche 4 bis 7, wobei die N Speicher Schieberegister sind.

9. Vorrichtung zum Synchronisieren von analogen Daten gemäß einem der Ansprüche 4 bis 8, wobei die Vielzahl von Wandlern N Wandler beinhaltet, wobei jeder Wandler einen einzelnen Wandlungskern aus den N Wandlungskernen beinhaltet.

10. Verfahren gemäß Anspruch 1, wobei das externe Synchronisationssignal (SYNC_ext) jedem Wandler aus der Vielzahl von Wandlern über eine jeweilige Verzögerungsleitung zwischen der Steuereinheit (UC) und jedem Wandler geliefert wird.

11. Verfahren gemäß Anspruch 1, wobei:
das externe Synchronisationssignal (SYNC_ext) einem ersten Wandler der Vielzahl von Wandlern geliefert wird, wobei jeder Wandler der Vielzahl von Wandlern eine Synchronisationsschaltung beinhaltet und wobei die Synchronisationsschaltungen der Vielzahl von Wandlern eine serielle Übertragungskette für das externe Synchronisationssignal bilden; und wobei die Erzeugung des internen Synchronisationssignals Folgendes beinhaltet:
Erzeugen, in dem ersten Wandler, des internen Synchronisationssignals (SYNC_int1) aus dem externen Synchronisationssignal, das an einem Eingang der Synchronisationsschaltung des ersten Wandlers empfangen wird; und
Erzeugen, in jedem verbleibenden Wandler aus der Vielzahl von Wandlern, des internen Synchronisationssignals (SYNC_int2, SYNC_intl) aus dem internen Synchronisationssignal, das von einem vorhergehenden Wandler in der seriellen Übertragungskette übertragen wird und an einem Eingang der Synchronisationsschaltung des Wandlers ankommt.

## Claims

1. A method for synchronising analogue data (Data_anal, Data_ana2, Data_anal) at an output of a plurality of digital/analogue converters (DAC, DAC1, DAC2, DACI), comprising at least one conversion core (C, C1, C2), on an active edge of a common reference clock (Clk), wherein the method comprises the following steps:
a) Supplying an external synchronisation signal (SYNC_ext), emitted by a control unit (UC), to at least one converter of the plurality of converters, and supplying a clock signal of the common reference clock to the plurality of converters;
b) Generating, within each converter of the plurality of converters, an internal synchronisation signal (SYNC_int, SYNC_int1, SYNC_int2, SYNC_intl) based on the external synchronisation signal, such that all the internal synchronisation signals are aligned on an active edge of the common reference clock;
c) Generating, by means of at least one electronic circuit internal to each converter of the plurality of converters, a start signal (START1, START2, STARTI) which represents the start of the sending of digital data (Data_numl, Data_num2, Data_numl) by the control unit, on each core of the plurality of converters, and counting a number of clock strokes between the generation of the start signal and the generation of the internal synchronisation signal for each of the cores of the plurality of converters; and
d) Applying a delay Ri (RI, R2, RI) to each core i of the plurality of converters, equal to the difference between the highest number counted in step c) and the number counted in step c) for the core i, i being an integer between 1 and the number of cores of the plurality of converters.

2. The method for synchronising analogue data according to claim 1, wherein the internal synchronisation signals are generated in step b) by resampling the external synchronisation signal.

3. The method for synchronising analogue data according to one of the preceding claims, wherein the converters of the plurality of converters form a serial transmission chain for the external synchronisation signal, and step a) also comprises:
- initialising, in each converter of the plurality of converters, a synchronisation circuit (CS, CS1, CS2, CSI) including at least one polarity parameter defining, as polarity of a reference clock edge, for detecting signals at the input of the synchronisation circuit of the converters, the polarity of the reference clock active edge or the opposite polarity; and
step b) also comprises:
- detecting a synchronisation signal (SYNC_ext, SYNC_int1, SYNC_int2) at the input of the synchronisation circuits of each converter, on a reference clock edge, which has the polarity defined by the value of the polarity parameter of the synchronisation circuit; and
- aligning, on the following active edge, the detected signal in order to supply an internal synchronisation signal (SYNC_int1, SYNC_int2, SYNC_intl) aligned on a reference clock active edge at an output of the synchronisation circuit of the converter.

4. A device for synchronising analogue data at an output of the plurality of digital/analogue converters on an active edge of the common reference clock (Clk) for performing the method according to the preceding claim, the device comprising:
- the plurality of digital/analogue converters (DAC, DAC1, DAC2, DACI) comprising:
- N conversion cores (C, C1, C2) and
- N memories (M, M1, M2), each converter comprising at least one digital input, at least one analogue output, at least one of the N memories, at least one of the N conversion cores and a synchronisation circuit (CS, CS1, CS2, CSI) connected to the digital input, the synchronisation circuits of the converters being connected to one another in a cascade, the memories of the converters each being connected to a conversion core of the converter and the synchronisation circuit of the converters being configured so as to generate an internal synchronisation signal (SYNC_int, SYNC_int1, SYNC_int2, SYNC_intl) and so that the internal synchronisation signals generated are aligned on an active edge of a common clock, and N being an integer greater than or equal to 1; and
- the control unit (UC) configured so as to send a signal from the common reference clock (Clk), the external synchronisation signal (SYNC_ext) and digital data (Data_num1, Data_num2, Data_numl) to each converter;
**characterised in that** each converter also comprises a data decoding circuit (Dec1, Dec2, Dec), comprising a counter (Cpt, Cpt1, Cpt2), for each conversion core included in the converter, the data decoding circuits being placed at an output of the synchronisation circuit and at an input of the memories and configured so as to generate the start signals (START1, START2, STARTI) which represent a start of the sending of digital data on a conversion core and each counter being configured so as to count a number of clock strokes between the generation of the start signal and the generation of the internal synchronisation signal of the conversion core, and **in that** the i^{th} memory is configured so as to apply the delay Ri (R1, R2, RI) to the i^{th} conversion core, i being an integer between 1 and N.

5. The device for synchronising analogue data according to the preceding claim, wherein the control unit comprises at least one programmable logic circuit configured to send the external synchronisation signal.

6. The device for synchronising analogue data according to one of claims 4 or 5, wherein the control unit comprises at least one programmable logic circuit configured to send the digital data.

7. The device for synchronising analogue data according to one of claims 4 to 6, wherein the control unit is also configured to receive the number of clock strokes counted by the N counters, to determine the delays Ri and to supply, to the N memories, a delay value Ri to be applied to the i^{th} conversion core.

8. The device for synchronising analogue data according to one of claims 4 to 7, wherein the N memories are shift registers.

9. The device for synchronising analogue data according to one of claims 4 to 8, wherein the plurality of converters comprises N converters, each converter comprising a single conversion core from the N conversion cores.

10. The method according to claim 1, wherein the external synchronisation signal (SYNC_ext) is supplied to each converter of the plurality of converters via a respective delay line between the control unit (UC) and each converter.

11. The method according to claim 1, wherein:
the external synchronisation signal (SYNC_ext) is supplied to a first converter of the plurality of converters, wherein each converter of the plurality of converters comprises a synchronisation circuit, and wherein the synchronisation circuits of the plurality of converters form a serial transmission chain for the external synchronisation signal; and
the generation of the internal synchronisation signal comprises :
generating, in the first converter, the internal synchronisation signal (SYNC_intl) from the external synchronisation signal received at an input of the synchronisation circuit of the first converter; and
generating, in each remaining converter of the plurality of converters, the internal synchronisation signal (SYNC_int2, SYNC_intl) from the internal synchronisation signal transmitted by a preceding converter in the serial transmission chain and arriving at an input of the synchronisation circuit of the converter.
